# EUROPÄISCHE PATENTSCHRIFT

(11) **EP 0 513 642 B1**
(45) Veröffentlichungstag und Bekanntmachung des Hinweises auf die Patenterteilung: **04.09.1996**
(21) Anmeldenummer: 92107609.7
(22) Anmeldetag: 06.05.1992
(51) Int. Cl.: H01L 39/24

(54) **Verfahren zur Herstellung dünner Polyimidschutzschichten auf keramischen Supraleitern oder Hochtemperatursupraleitern**
Method of making thin polyimide protection layers on ceramic superconductors or high temperature superconductors
Procédé de fabrication des couches minces de protection en polyimide sur supraconducteurs en céramique ou supraconducteurs à haute température

(30) Priorität: 15.05.1991 DE 4115872
(43) Veröffentlichungstag der Anmeldung: 19.11.1992
(73) Patentinhaber: BASF Aktiengesellschaft, 67063 Ludwigshafen (DE)
(72) Erfinder: Schrepp, Wolfgang, Dr., W-6900 Heidelberg (DE); Haehnle, Hans-Joachim, Dr., W-6700 Ludwigshafen (DE); Grunze, Michael, Prof. Dr., W-6903 Neckargemuend (DE)

(56) Entgegenhaltungen:
- EP-A- 0 247 358
- EP-A- 0 301 962
- EP-A- 0 324 615
- IEEE ADVANCED SEMICONDUCTOR MANUFACTURING CONFERENCE AND WORKSHOP, 11. September 1990, Danvers, MA, US, Seiten 72-74; C. Schuckert et al.: "Polyimide Stress Buffers in IC Technology"
- IEEE TRANSACTION ON COMPONENTS, HYBRIDS AND MANUFACTURING TECHNOLOGY, Bd. 13, Nr. 1, März 1990, New York, US, Seiten 214-218; J.J. Burack et al.: "Enhanced Moisture Protection of Electronic Devices by Ultra-Thin Polyimide Films"

## Beschreibung

Die Erfindung betrifft ein Verfahren zur Herstellung dünner Polyimidschutzschichten auf keramischen Supraleitern oder Hochtemperatursupraleitern, wobei entweder die dem Polyimid zugrundeliegenden Polyamidsäuren oder deren Ausgangssubstanzen auf die Supraleiter- oder Hochtemperatursupraleiteroberflächen aufgebracht und imidisiert werden oder Polyimidlösungen auf die Supraleiter- oder Hochtemperatursupraleiteroberfläche aufgebracht und bei erhöhter Temperatur getrocknet werden.

Es ist bekannt, daß Hochtemperatursupraleiter unter Umwelteinflüssen, wie Luft, Feuchtigkeit, thermischer und mechanischer Belastung usw., Degradationserscheinungen zeigen (vgl. D. Majundar, D. Chatterjee, G. Pav.-Pujalt: Physica C, 158(3) (1989), die sich in einem Absinken der Sprungtemperatur dokumentieren. Eine mögliche Ursache ist die Auslagerung von Sauerstoff (z.B. bei YBa₂Cu₃O₇₋ₓ).

Wünschenswert wäre daher ein verfahren, mit dem sich dielektrische Polymerschichten zur Passivierung und elektrischen Isolation auf die Oberfläche von Hochtemperatursupraleitern aufbringen lassen. Hierdurch kann der Supraleiter unter Bewahrung der supraleitenden Eigenschaften vor Umwelteinflüssen geschützt werden. Die elektrische Isolation mit Hilfe der dielektrischen Schichten erlaubt den Einsatz von Supraleiterformteilen (z.B. in Magneten und Bauteilen von Elektromotoren) und von Supraleiterschichten in elektronischen Bauelementen.

Zur Passivierung werden verschiedene Verfahren beschrieben, so z.B. in JP 60 145 375 A2 und JP 01 246 105 A2, die Aufbringung von C-Schichten durch Magnetron-Sputtern. Von S. Morohashi, H. Tamura, A. Yoshida und S. Hasuo in Mater. Sci. Eng. A 109 (1989), 321 wird auch der Schutz mittels Plasmapolymerisation beschrieben. Über die Beschichtung mit organischen Harzschichten (Fluorpolymere, Epoxyharze, Siloxane) wird in EP 305 168 A2 berichtet, ferner über die Verwendung von Polyimiden in JP 63 318 015 A2. Ein ebenfalls häufig beschrittener Weg zur Verhinderung der schädlichen Sauerstoffauslagerung ist das Einbringen polymerer (z.B. Ethylcellulose) oder naßchemischer Materialien (z.B. Oxalate) während des Herstellungsprozesses der Keramik (vgl. R.P. Vasquez, M.C. Foote, B.D. Hunt; Appl. Phys. Lett., 55 (1989) 1801). Anorganische Schutzschichten wie Edelmetalle, Übergangsmetalle, SiO₂, Si₃N₄, AlN sind von E. Weschke, C. Laubschat, M. Domke, M. Bodenbach, G. Kaindle, J.E. Ortega und M. Mirand in Z. Phys. B: Condens. Matter, 74 (2) (1989) 191 beschrieben.

Die Herstellung organischer Schutzschichten mit Hilfe von Aufdampfverfahren ist von R.N. Lamb und M. Grunze in Surf. Sci., 204 (1988) 183 sowie von J.R. Salem, F.O. Sequeda, J. Duran, W.J. Lee, R.M. Yang in J. Vac. Sci., Technol., A4 (3) (1986) 369 beschrieben.

Die Herstellung organischer Schutzschichten nach der Langmuir-Blodgett-Technik bzw. nach der Langmuir-Schäfer-Technik wurde von M.C. Petty in W.J. Feast und H.S. Munro (Hrsg.) in Polymer Surfaces and Interfaces, J, Willey & Sons, Chichester 1987, S. 163 ff. behandelt, die Self-Assembly-Technik von R. Maoz und J. Sagiv in "Thin Solid Films" 132 (1985) 135. Die Applikation geeignet modifizierter Polymechacrylate, Polyamide, Polyurethane und Polyester nach dem Langmuir-Blodgett-Verfahren ist auch der Publikation von F. Embs, D. Funhoff, A. Laschewsky, U. Licht, H. Ohst, W. Praß, H. Ringsdorf, G. Wegner und R. Wehrmann in Adv. Mater., 3 (1991) 25 zu entnehmen. Wie aus EP 02 47 358 A2 hervorgeht, können Polyamidsäuren auch nach dem Langmuir-Blodgett- oder Langmuir-Schäfer-Verfahren auf das zu beschichtende Substrat abgeschieden werden.

Die EP-0301962-A2 bezieht sich auf einen supraleitenden dünnen Film, der auf einem MgO- oder SrTiO₃-Substrat abgeschieden und mit einer Schutzschicht eines Polymers, wie Polyimid-, Silikon- oder Epoxyharz versehen ist.

In IEEE Transaction on components, Hybrides and Manufacturing Technology, Bd. 13, Nr. 1, März 1990, Seiten 214 - 218 werden nach der Langmuir-Blodgett-Methode hergestellte dünne Polyimidfilme auf elektronischen Geräten zur Steigerung des Schutzes gegen Feuchtigkeit beschrieben.

Eine Imidisierung von auf Hochtemperatursupraleitern aufgebrachten Polyamidsäureschichten (gelöste Polyamidsäure, aufgedampfte oder durch Langmuir-Blodgett-Technik abgeschiedene Polyamidsäure) im Schutzgas oder im Vakuum führt, bedingt durch Ausdifffusion von Gittersauerstoff aus den keramischen Supraleitern, zum Abbau des Polymeren und letztlich zum Verlust der supraleitenden Eigenschaften.

Aufgabe der vorliegenden Erfindung ist, ein Verfahren aufzuzeigen, durch das diese Nachteile vermieden werden.

Überraschenderweise wurde gefunden, daß sich die Polyamidsäuren ohne Störung in Polyimid umsetzen lassen bzw. auch die Trocknung von auf den Supraleiter aufgebrachten Polyimidlösungen ohne Störung durchführen läßt und die Ausdiffusion des Gittersauerstoffes aus dem keramischen Supraleiter unterdrückt wird, wenn die Imidisierung bzw. Trocknung in einer oxidierenden Sauerstoffatmosphäre von 1 bis 5 bar (atm) erfolgt. Der Erfolg dieser Maßnahme läßt sich anhand des XPS-Spektrums nachweisen.

Gegenstand der vorliegenden Erfindung ist ein Verfahren zur Herstellung dünner Polyimidschutzschichten auf keramischen Supraleitern oder Hochtemperatursupraleitern, wobei Polyimidlösungen oder die dem Polyimid zugrundeliegenden Polyamidsäuren oder deren Ausgangssubstanzen auf die Supraleiter- oder Hochtemperatursupraleiteroberfläche aufgebracht und imidisiert werden, das dadurch gekennzeichnet ist, daß die Trocknung bzw. die Imidisierung in einer oxidierenden Sauerstoffatmosphäre von 1 bis 5 bar (atm) erfolgt.

Die dem Polyimid zugrundeliegende Polyamidsäure kann dabei mittels Langmuir-Blodgett- oder Langmuir-Schäfer-Technik auf die Supraleiter- oder Hochtemperatursupraleiteroberfläche aufgebracht werden, oder die Ausgangssubstanzen der den Polyimiden zugrundeliegenden Polyamidsäuren können aus der Dampfphase auf die (Hochtemperatur-) Supraleiteroberfläche aufgebracht werden.

Die Polyimidlösung kann auch mittels der Schleudertechnik (spin coating) auf die Supraleiter- oder Hochtemperatursupraleiteroberfläche aufgebracht werden. An Stelle der keramischen Supraleiter oder Hochtemperatursupraleiter können auch andere anorganische oxidische Materialien nach dem erfindungsgemäßen Verfahnren mit dünnen Polyimidschutzschichten versehen werden.

Zum erfindungsgemäßen Verfahren ist im einzelnen folgendes auszuführen.

Die Herstellung der dem jeweiligen Polyimid zugrundeliegenden Polyamidsäuren ist bekannt. Im allgemeinen werden diese durch Umsetzung äquimolarer Mengen von Tetracarbonsäureanhydriden und Diaminoverbindungen erhalten.

Als Tetracarbonsäuredianhydride bevorzugt sind Pyromellithsäuredianhydrid und Benzophenontetracarbonsäuredianhydrid. Beispiele für weitere Tetracarbonsäuredianhydride sind 2,3,9,10-Perylentetracarbonsäuredianhydrid, 1,4,5,8-Naphthalintetracarbonsäuredianhydrid, 2,6-Dichlornaphthalin-1,4,5,8-tetracarbonsäuredianhydrid, 2,7 Dichlornaphthalin-1,4,5,8-tetracarbondsäuredianhydrid, Phenanthren-1,8,9,10-tetracarbonsäuredianhydrid, 3,3'4,4'-Biphenyltetracarbonsäuredianhydrid, 2,2',3,3'-Biphenyltetracarbonsäuredianhydrid, 4,4'-Isopropylidendiphthalsäureanhydrid, 3,3'-Isopropylidendiphthalsäureanhydrid, 4,4'-Oxydiphthalsäureanhydrid, 4,4'-Sulfonyldiphthalsäureanhydrid, 3,3'-Oxydiphthalsäureanhydrid, 4,4'-Methylendiphthalsäureanhydrid, 4,4'-Thiodiphthalsäureanhydrid, 4,4'-Acetylidendiphthalsäureanhydrid, 2,3,6,7-Naphthalintetracarbonsäuredianhydrid, 1,2,4-5-Naphthalintetracarbonsäuredianhydrid, 1,2,5-6-Naphthalintetracarbonsäuredianhydrid, Benzol-1,2,3-4-tetracarbonsäuredianhydrid, Thiophen-2,3,4,5-tetracarbonsäuredianhydrid, 1-(3',4'-Dicarboxyphenyl)-1,3,3-trimethylindan-5,6-dicarbonsäuredianhydrid, 1-(3',4'-Dicarboxyphenyl)-1,3,3-trimethylindan-6,7-dicarbonsäuredianhydrid, 1-(3',4'-Dicarboxyphenyl)-3-methylidan-5,6-dicarbonsäuredianhydrid, 1-(3',4'-Dicarboxyphenyl)-3-methylidan-6,7-dicarbonsäuredianhydrid, 3,3',4,4'-Benzophenontetracarbonsäureanhydrid, 4,5,3',4'-Benzphenontetracarbonsäureanhydrid.

Als Diaminoverbindungen eignen sich übliche aromatische Diaminoverbindungen, vorzugsweise der 4,4'-Diaminodiphenylether (= 4,4'-Oxydianilin). An Stelle oder in Mischung mit 4,4'-Diaminodiphenylether können beispielsweise auch andere Diamine eingesetzt werden, beispielsweise 4,4-Methylenbis(o-chloranilin), 3,3'-Dichlorbenzidin, 3,3'-Sulfonyldianilin, 4,4'-Diaminobenzophenon, 1,5-Diaminonaphthalin, Bis-(4-aminophenyl)-dimethylsilan, Bis-(4-aminophenyl)-diethylsilan) Bis-(4-aminophenyl)-diphenylsilan, Bis-(4-aminophenyloxy)-dimethylsilan, Bis-(4-aminophenyl)ethylphosphinoxid, N-(Bis-(4-aminophenyl))-N-methylamin, N-(Bis-(4-aminophenyl))-N-phenylamin, 4,4'-Methylbis(3-methylanilin), 4,4'-Methylen-bis(2-ethylanilin), 4,4'-Methylenbis-(2-methoxyanilin), 5,5'-Methylenbis(2-aminophenol), 4-4'-Methylenbis-(2-methylanilin), 5,5'-Oxybis-(2-aminophenol), 4,4'-Thiobis-(2-methylanilin), 4,4'-Thiobis-(2-methoxyanilin), 4,4'-Thiobis-(2-chloranilin), 4,4'-Sulfonylbis-(2-ethoxyanilin), 4,4'-Sulfonylbis-(2-chloranilin), 5,5'-Sulfonylbis-(2-aminophenol), 3,3'-Dimethyl-4,4'-Diaminobenzophenon, 3,3'-Dimethoxy-4,4'-diaminobenzophenon, 3,3'-Dichlor-4,4'-diaminobenzophenon, 4,4'-Diaminobiphenyl, m-Phenylendiamin, p-Phenylendiamin, 4,4'-Methylendianilin, 4,4'-Thiodianilin, 4,4'-Sulfonyldianilin, 4,4'-Isopropylidendianilin, 3,3'-Dimethylbenzidin, 3,3'-Dimethoxybenzidin, 3,3'-Dicarboxybenzidin, Diaminotoluol.

In organischen stark polaren Lösungsmitteln, wie Phenol, Kresol, Dimethylformamid, Dimethylacetamid bzw. insbesondere N-Methylpyrrolidon lösliche Polyimide sind im allgemeinen solche, die aus entsprechend sterisch gehinderten aromatischen Diamin- bzw. Tetracarbonsäuredianhydrid-Komponenten aufgebaut sind, z.B. aus alkyl-, aryl- bzw. alkylarylsubstituierten aromatischen Diaminen oder 4,4'-Isopropylidendianilin, in dem die H-Atome der Isopropylidengruppe durch Fluoratome ersetzt sind, und 4,4'-Isopropylidendiphthalsäureanhydrid, in dem die H-Atome der Isopropylidengruppe durch Fluoratome substituiert sind, bzw. Benzophenontetracarbonsäuredianhydrid mit sterisch gehinderten aromatischen Diaminoverbindungen. Beispiele für derartige lösliche Polyimide sind durch die folgenden Formeln (Wiederholungseinheiten) gegeben:

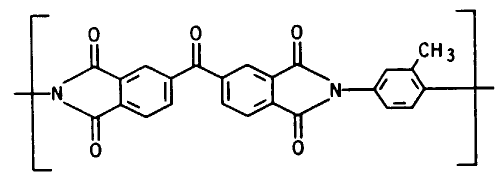

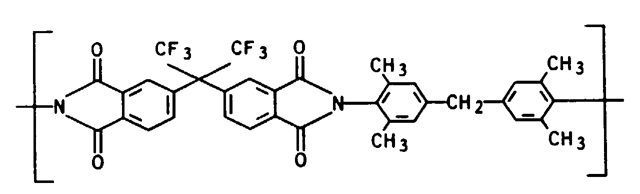

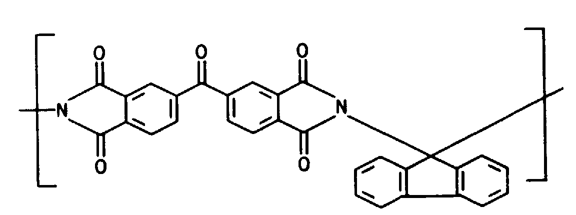

Die Lösung einer einem entsprechenden Polyimid zugrundeliegenden Polyamidsäure in beispielsweise N-Methylpyrrolidon kann in üblicher Weise durch Aufschleudern (spin-coating) auf das zu beschichtende keramische Substrat (z.B. einen keramischen Supratleiter) aufgebracht und bei Temperaturen von etwa 100 bis 150°C das Lösungsmittel abgedampft werden.

Erfindungsgemäß wird dann in einer oxidierenden Atmosphäre bei Temperaturen über 150°C bis zu 400°C die Imidisierung unter Wasserabspaltung vorgenommen. Alternativ zur Applikation von Polyamidsäurelösungen auf keramische Supraleiter kann die Polyamidsäure durch Aufdampfen (Gasphasenabscheidung) ihrer Aufbaukomponenten Diamin und Tetracarbonsäuredianhydrid oder nach dem Langmuir-Blodgett-, bzw. Langmuir-Schäfer-Verfahren durch mehrfaches Auftragen von auf der Wasseroberfläche eines Langmuir-Troges gespreiteten monomolekularen Schichten langkettiger Ammoniumsalze von Polyamidsäure (im allgemeinen 6 bis 50, vorzugsweise 10 bis 30 Schichten) auf die Oberfläche eines keramischen Supraleiters aufgebracht und dann erfindungsgemäß in oxidierender Atmosphäre imidisiert werden. Eine Imidisierung unter zusätzlicher Einbeziehung wasserentziehender Mittel, wie z.B. Acetanhydrid in Pyridin ist ebenfalls möglich.

Die oben bereits erwähnten sterisch gehinderten Polyimide, die noch in polaren organischen Lösungsmitteln, wie N-Methylpyrrolidon löslich sind, können in Form ihrer Lösungen direkt auf die keramischen Supraleiter aufgeschleudert werden. Nach Entfernung der Hauptmenge des Lösungsmittels bei Temperaturen um 100°C erfolgt die Trocknung des Imidfilms erfindungsgemäß in oxidierender Atmosphäre bei Temperaturen über 150°C. Beim Schleuderverfahren werden im allgemeinen Schichtdicken von 500 bis 1000 nm erhalten, es können jedoch auch größere Schichtdicken erzeugt werden.

Das erfindungsgemäße Verfahren eignet sich zur Herstellung dünner Polyimidschutzschichten auf allen möglichen anorganischen oxidischen Materialien, wie z.B. an der Oberfläche oxidierte Siliciumwafer, CMOS-Strukturen, insbesondere für Polyimidschutzschichten auf keramischen Supraleitern bzw. Hochtemperatursupraleitern, wie sie beispielsweise auch hinsichtlich ihrer Zusammensetzung den Publikationen in Phys. Bl. 43 (1987) Nr. 4, 96, Phys. Bl. 43 (1987) Nr. 9, 357-363 und Phys. Bl. 46 (1990) Nr. 11, 419-425, zu entnehmen sind. Als Beispiel für derartige Hochtemperatursupraleiter seien YBa₂Cu₃O₇, YBa₂Cu₃O₇₋ₓ sowie (La,M)₂CuO₄ mit M = Ca, Sr oder Ba genannt, die beispielsweise als poröse Sinterkörper oder als Film auf beispielsweise Aluminiumoxid- oder Strontiumtitanat-Substraten durch Sputtern oder Laserdeposition hergestellt werden können.

Unter oxidierender Atmosphäre im Sinne der Erfindung werden Sauerstoff, Sauerstoff/Luft-Gemische und Stickoxide NOₓ sowie N₂O₂ verstanden. Bevorzugt ist reiner Sauerstoff, der mit einem Druck von 1 bis 5 atm. als oxidierende Atmosphäre bei der Imidisierung bzw. Trocknung, beispielsweise über einen Zeitraum von etwa 1 bis 5 Stunden eingesetzt wird.

Nach dem erfindungsgemäßen Verfahren lassen sich dielektrische Polyimidschichten zur Passivierung und elektrischen Isolation auf Hochtemperatursupraleiteroberflächen aufbringen. Die Passivierung schützt die Supraleiter vor Umwelteinflüssen, um die supraleitenden Eigenschaften zu bewahren. Die elektrische Isolation mit dielektrischen Polyimidschichten erlaubt den Einsatz der Supraleiterformteile z.B. in Magneten und Bauteilen von Elektromotoren und von Supraleiterschichten in elektronischen Bauelementen.

Der Nachweis, daß die Imidisierung in einer oxidierenden Atmosphäre störungsfrei möglich ist und eine Ausdiffusion des Gittersauerstoffs aus dem keramischen Supraleiter unterbleibt, ist durch das XPS-Spektrum möglich.

Man mißt im Röntgenphotoelektronenspektrum (= XPS-Spektrum) die Bindungsenergien und die charakteristische Bandenform des C1s, O1s und N1s der Polyimids und des dem Polyimid entsprechenden stöchiometrischen Verhältnisses von C:O:N = 22:5:2 (für das Polyimid auf Basis Pyromellithsäuredianhydrid und 4,4'-Oxidianilin).

Im Falle des nach der Langmuir-Blodgett-Methode auf einen keramischen Supraleiter aufgebrachten Films des Octadecylammoniumsalzes der Polyamidsäure aus Pyromellithsäuredianhydrid und 4,4'-Oxidianilin bzw. des direkten Aufdampfens eines äquimolaren Gemisches aus Pyromellithsäuredianhydrid und Oxidianilin auf den keramischen Supraleiter und der Imidisierung in oxidierender Atmosphäre bei Temperaturen zwischen 200 und 350°C, vorzugsweise 250 bis 300°C erhält man gemäß den Meßergebnissen der XPS-Spektren einen normalen unbeschädigten Polymerfilm mit den gewünschten dielektrischen Eigenschaften.

In den folgenden Beispielen soll die Erfindung näher erläutert werden. Die angegebenen Teile und Prozente sind, soweit nicht anders angegeben, Gewichtsteile und Gewichtsprozente.

### Beispiel 1

### Aufbringung von Passivierungsschichten mittels Langmuir-Blodget-Technik

Auf der Wasseroberfläche eines Langmuirtroges (Fw1 oder FW2 der Fa. Lauda, Königshofen) wird eine Lösung des langkettigen Ammoniumsalzes einer Polyamidcarbonsäure der Formel 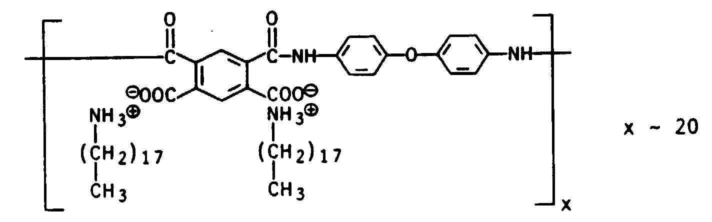 gespreitet.

Als Lösungsmittel wird eine Mischung aus einem Teil N-Methylpyrrolidon (= NMP) und neun Teilen Chloroform verwendet. Die Konzentration beträgt etwa 1 mg pro ml Lösungsmittel. Nach dem Verdampfen des Chloroforms wird der Oberflächenfilm bis zu einem Oberflächendruck von 25 mN/m komprimiert. Die Subphase besteht aus mit einer Milli-Q-Anlage gereinigtem Wasser von 18 MOhm cm und etwa pH 5,6. Die Subphasentemperatur beträgt 15°C. Das Ein- und Austauchen des zu beschichtenden Supraleiters (Yttrium-Barium-Kupfer-Oxid-Film auf Aluminiumoxid bzw. Strontiumtitanat) erfolgt mit Hilfe des Filmliftes FL1 der Fa. Lauda bei einer Tauchgeschwindigkeit von 4 mm/min. In der Regel werden pro Tauchzyklus zwei monomolekulare Schichten übertragen, insgesamt werden 20 Schichten auf die Supraleiteroberfläche aufgetragen. Die Imidisierung wird in einem geheizten Durchflußreaktor in statischer Sauerstoffatmosphäre bis zu einem Druck von 2 atm. O₂ durchgeführt. Die Proben wurden in die Reaktionskammer transferiert und dann in 50°C-Schritten mit jeweiligen Verweilzeiten bei konstanter Temperatur von 15 min. auf 350°C geheizt. Nach jeder Temperaturbehandlung wurde der Film mit Hilfe der oben erwähnten Röntgenphotoelektronenspektroskopie auf seine Elementzusammensetzung und Stöchiometrie untersucht. Die Resultate zeigten, daß die Imidisierung in Sauerstoffatmosphäre zu stöchiometrischen Polyimidfilmen auf Hochtemperatursupraleitern - ohne Verlust der supraleitenden Eigenschaften - und auf anderen anorganischen oxidischen Substraten führt.

### Beispiel 2

### Aufbringen von Passivierungsschichten durch Gasphasenabscheidung von 1,2,4,5-Benzoltetracarbonsäuredianhydrid und 4,4'-Oxidianilin.

Die Beschichtung der Hochtemperatursupraleiteroberfläche (YBa₂Cu₃O₇₋ₓ-Film auf Aluminiumoxid) erfolgte in einem Vakuumsystem, in dem zwei geeichte Verdampferquellen für das Dianhydrid und das Diamin installiert sind. Die Hochtemperatursupraleiteroberfläche wird in den Punkt plaziert, in dem etwa gleiche Aufdampffilme der Ausgangsverbindungen eingestellt werden können. Die Substratoberfläche befindet sich bei Raumtemperatur, die Sublimation des Dianhydrids und des Diamins erfolgt bei T≥100°C aus der Verdampferzelle. Durch Einstellen der Temperatur der Verdampferzelle lassen sich Aufdampfraten (bestimmt mit einem Schwingquarz) von einigen Angström pro Minute bis zu etlichen Nanometern pro Sekunde einstellen, so daß Polyamidsäurefilme mit Schichtdicken von einigen Angström bis in den Millimeterbereich produziert werden können, da das Dianhydrid und das Diamin in der Adsorbatphase spontan zu Polyamidsäure reagieren.

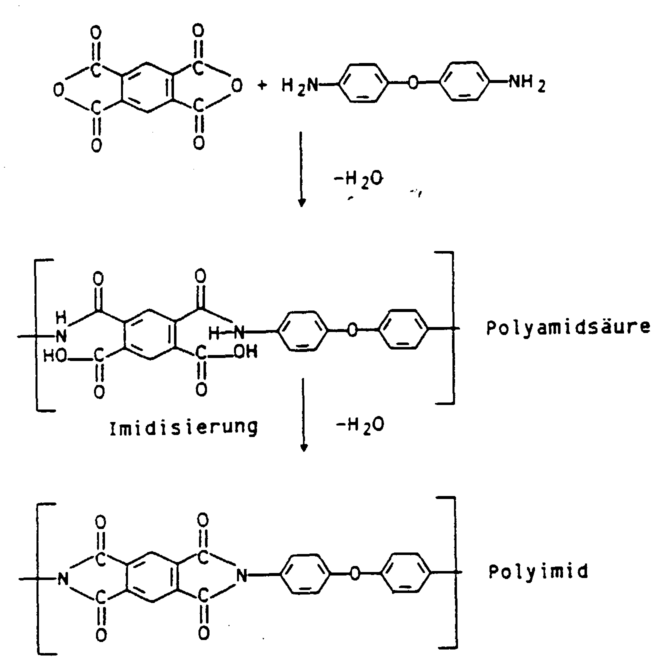

### Imidisierung der Polyamidsäure

Die Imidisierung der aufgedampften Polyamidsäurefilme wurde in einem geheizten Durchflußreaktor und in einer statischen Sauerstoffatmosphäre bis zu einem Druck von 2 atm. O₂ durchgeführt. Die Proben wurden in die Reaktionskammer transferiert und dann in 50°C- Schritten mit jeweiligen Verweilzeiten bei konstanten Temperaturen von 15 min. auf 350°C geheizt. Nach jeder Temperaturbehandlung wurde der Film mit Hilfe der Röntgenphotoelektronenspektroskopie auf seine Elementzusammensetzung und Stöchiometrie untersucht.

Die Resultate zeigten, daß die Imidisierung der Filme in Sauerstoffatmosphäre zu stöchiometrischen Polyimidfilmen auf Hochtemperatursupraleitern - ohne Verlust der supraleitenden Eigenschaften - und auf anderen anorganischen Substraten führt und so homogene Filme präpariert werden können.

### Beispiel 3

### Aufbringen von Passivierungsschichten mittels Schleudertechnik (spin coating) auf Hochtemperatursupraleiter.

In N-Methylpyrrolidon gelöste Polyimide, die jeweils aus folgenden wiederholungseinheiten aufgebaut sind, 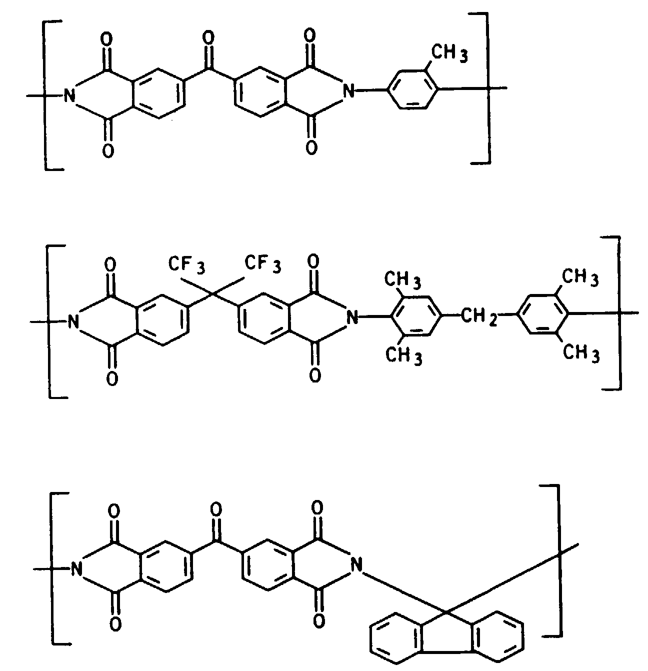 werden auf Supraleiteroberflächen (YBa₂Cu₃O₇₋ₓ) aufgeschleudert, bei Temperaturen Zwischen 100 und 150°C vorgetrocknet, so daß sich Film-Schichtdicken von 500 bis 1000 nm ergeben. Die Trocknungszeiten der Filme in Sauerstoffstmosphäre kann hier bei Temperaturen von 250-350°C auf unter 60 min. verkürzt werden.

## Patentansprüche

1. Verfahren zur Herstellung dünner Polyimidschutzschichten auf keramischen Supraleitern oder Hochtemperatursupraleitern, wobei Polyimidlösungen oder die dem Polyimid zugrundeliegenden Polyamidsäuren oder deren Ausgangssubstanzen auf die Supraleiter- oder Hochtemperatursupraleiteroberfläche aufgebracht und imidisiert werden, dadurch gekennzeichnet, daß die Trocknung bzw. die Imidisierung in einer oxidierenden Sauerstoffatmosphäre von 1 bis 5 bar (atm) erfolgt.

2. Verfahren nach Anspruch 1 dadurch gekennzeichnet, daß die dem Polyimid zugrundeliegende Polyamidsäure mittels Langmuir-Blodgett- oder Langmuir-Schäfer-Technik auf die Supraleiter oder Hochtemperatursupraleiteroberfläche aufgebracht wird.

3. Verfahren nach Anspruch 1 dadurch gekennzeichnet, daß die Ausgangssubstanzen der den Polyimiden zugrundeliegenden Polyamidsäuren aus der Dampfphase auf die (Hochtemperatur-)Supraleiteroberfläche aufgebracht werden.

4. Verfahren anch Anspruch 1, dadurch gekennzeichnet, daß die Polyimidlösungen mittels der Schleudertechnik (spin coating) auf die Supraleiter- oder Hochtemperatursupraleiteroberfläche aufgebracht wird.

## Claims

1. A process for producing a thin protective polyimide layer on a ceramic or high temperature superconductor by applying a polyimide solution or the polyamic acid from which the polyimide will be derived, or starting substances for the acid, to the superconductor surface and drying or imidating, which comprises carrying out the drying or imidation in an oxidizing oxygen atmosphere of from 1 to 5 bar (atm).

2. A process as claimed in claim 1, wherein the polyamic acid from which the polyimide will be derived is applied to the superconductor surface using the Langmuir-Blodgett or Langmuir-Schäfer technique.

3. A process as claimed in claim 1, wherein the starting substances for the polyamic acid from which the polyimide will be derived are applied to the superconductor surface from the vapor phase.

4. A process as claimed in claim 1, wherein the polyimide solution is applied to the superconductor surface by spin coating.

## Revendications

1. Procédé pour appliquer des couches protectrices minces de polyimides sur des supraconducteurs céramiques ou des supraconducteurs à haute température, dans lequel on applique des solutions de polyimide ou les acides polyamidiques dont dérive le polyimide ou leurs produits de départ sur la surface du supraconducteur ou du supraconducteur à haute température et on imide, caractérisé par le fait que l'on sèche ou respectivement on imide en atmosphère oxydante par la présence d'oxygène à une pression de 1 à 5 bar (atm).

2. Procédé selon la revendication 1, caractérisé par le fait que l'acide polyamidique dont dérive le polyimide est appliqué sur le supraconducteur ou sur la surface du supraconducteur à haute température par la technique de Langmuir-Blodgett ou par la technique de Landmuit-Schäfer.

3. Procédé selon la revendication 1, caractérisé par le fait que les produits de départ des acides polyamidiques dont dérivent les polyimides sont appliqués en phase vapeur sur la surface du supraconducteur (à haute température).

4. Procédé selon la revendication 1, caractérisé par le fait que la solution de polyimide est appliquée à la surface du supraconducteur ou du supraconducteur à haute température par la technique de revêtement centrifuge (spin coating).
